# EUROPEAN PATENT APPLICATION

(11) **EP 4 668 504 A1**
(43) Date of publication of application: **24.12.2025**
(21) Application number: 24756569.0
(22) Date of filing: 19.01.2024
(51) Int. Cl.: H01S 5/0237

(54) **CHIP-ON-SUBMOUNT STRUCTURE**

(30) Priority: 15.02.2023 JP 2023022026
(71) Applicant: Fujikura Ltd., Tokyo 135-8512 (JP)
(72) Inventor: KAWAKAMI, Toshiyuki, Sakura-shi, Chiba 285-8550 (JP)
(74) Representative: Plasseraud IP
(86) International application number: PCT/JP2024/001428
(87) International publication number: WO 2024/171718

(57) **Abstract**

Provided is a chip-on-submount structure that is capable of suppressing distortions which can occur in a chip of a semiconductor laser. A chip-on-submount structure (1) includes: a chip (10) that includes a current injection stripe (161) which injects a current into an active layer (13); a distortion suppression layer (20) that covers the current injection stripe (161) and that is made of a metal; a submount (40) that includes an electrode layer (electrode pattern 42); and a solder layer (30) that is interposed between the distortion suppression layer (20) and the electrode layer (electrode pattern 42). In the distortion suppression layer (20), an unreacted layer (201) in which a component of the solder layer (30) is not diffused has a thickness of not less than 1.4 µm.

## Description

### Technical Field

The present invention relates to a chip-on-submount structure in which a chip of a semiconductor laser is mounted on a submount.

### Background Art

There has been known a chip of a high output power semiconductor laser that produces output power exceeding 10 W (see, for example, Fig. 9 of Patent Literature 1). Such a semiconductor laser achieves high output power by increasing the width of a current injection stripe, which is an electrode for injecting a current into an active layer. Such a chip achieves high output power by increasing the width of a current injection stripe for injecting a current into an active layer.

### Citation List

### [Patent Literature]

[Patent Literature 1]
Japanese Patent Application Publication Tokukaihei No. 9-36493

### Summary of Invention

### Technical Problem

In addition, it is important to reduce the manufacturing cost in manufacturing a chip of a semiconductor laser. One method for reducing the manufacturing cost of the chip includes size reduction of the chip. However, it is desired to avoid output power reduction from being caused in association with the size reduction of the chip. Thus, in order to reduce the size of the chip, a realistic option is not to shorten the length of the chip determined according to the length of the current injection stripe, but to decrease the width of the chip. However, the smaller the width of the chip, the greater the degree of difficulty in manufacturing a chip-on-submount structure.

In the chip-on-submount structure, an electrode layer is formed on one main surface of a submount. The chip is disposed such that the current injection stripe is close to the above-described electrode layer. In addition, the current injection stripe and the electrode layer are joined to each other using solder in a state in which the current injection stripe and the electrode layer are in continuity with each other.

In the step of joining this chip to the submount, a distortion may occur in the chip. In addition, even in a case where the semiconductor laser is driven after the manufacture, a distortion may occur in the chip. The smaller the width of the chip, the more likely these distortions are to occur. Thus, the distortion that has occurred in the chip becomes a cause of destabilization of the radial shape of laser light emitted from the semiconductor laser. That is, the smaller the width of the chip, the more likely the radial shape of the laser light emitted from the semiconductor laser is to be unstable.

A chip-on-submount structure in accordance with an aspect of the present invention has been attained in view of the above-described problem, and an object thereof is to provide a chip-on-submount structure that is capable of suppressing distortions that can occur in a chip.

### Solution to Problem

In order to solve the above problem, a chip-on-submount structure in accordance with an aspect of the present invention includes: a broad area type chip that includes an active layer and a current injection stripe which injects a current into the active layer; a distortion suppression layer that covers the current injection stripe and that is made of a metal; a submount that includes a substrate and an electrode layer which is provided on one main surface of the substrate; and a solder layer that is interposed between the distortion suppression layer and the electrode layer and that joins the chip and the submount. In the present chip-on-submount structure, a configuration is employed in which the distortion suppression layer includes a reaction layer, in which a component of the solder layer is diffused, and an unreacted layer, in which the component of the solder layer is not diffused, and the unreacted layer has a thickness of not less than 1.4 µm.

### Advantageous Effects of Invention

According to an aspect of the present invention, it is possible to provide a chip-on-submount structure that is capable of suppressing distortions that can occur in a chip of a semiconductor laser.

### Brief Description of Drawings

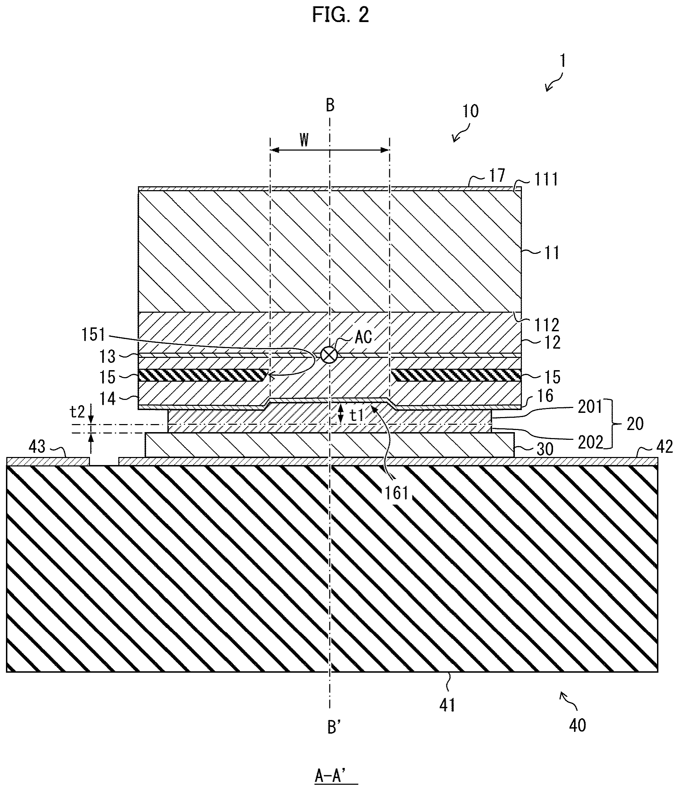

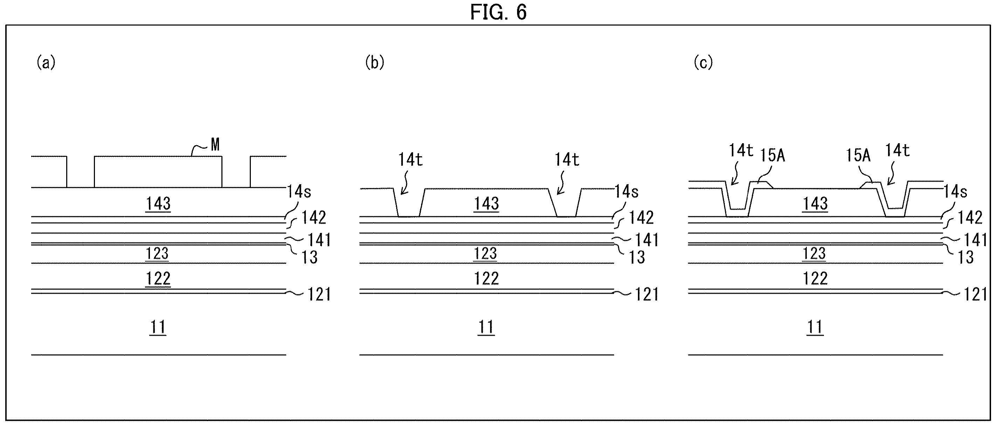

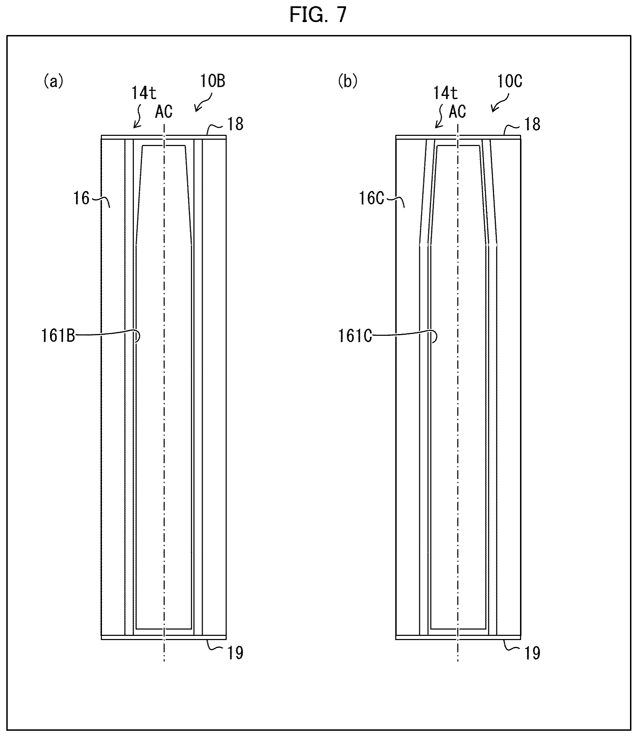

Fig. 1 is a perspective view of a chip-on-submount structure in accordance with an embodiment of the present invention.
Fig. 2 is a cross-sectional view of the chip-on-submount structure illustrated in Fig. 1.
(a) of Fig. 3 is a plan view of a chip provided in the chip-on-submount structure illustrated in Fig. 1 when the chip is seen from a current injection stripe side. (b) of Fig. 3 is a plan view of a variation of the chip illustrated in (a) of Fig. 3 when seen from the current injection stripe side.
(a) to (f) of Fig. 4 are cross-sectional views illustrating a method for manufacturing a first specific example of the chip illustrated in Fig. 2.

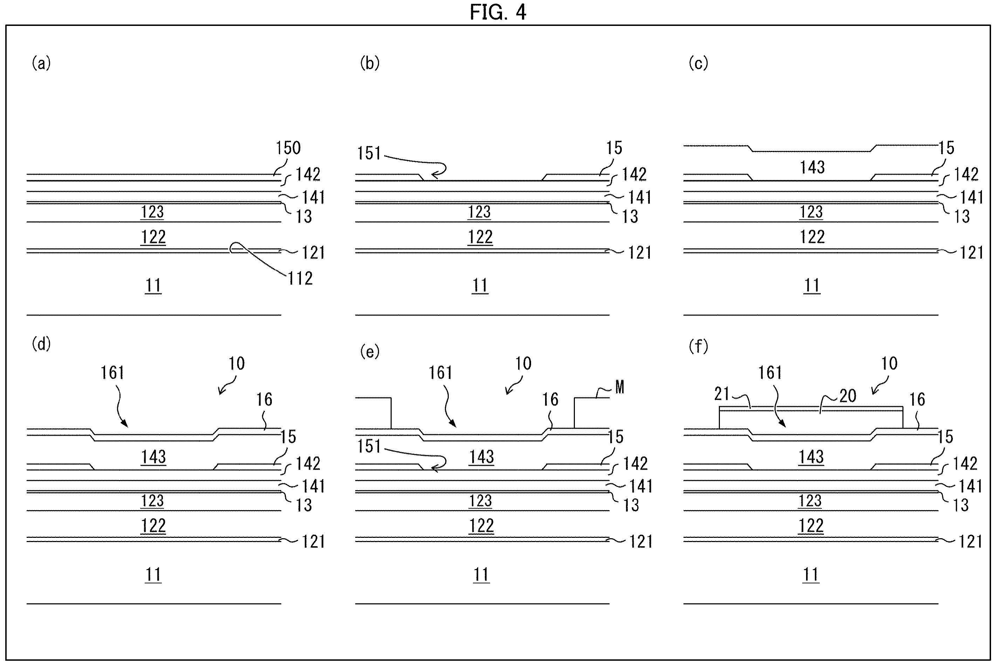

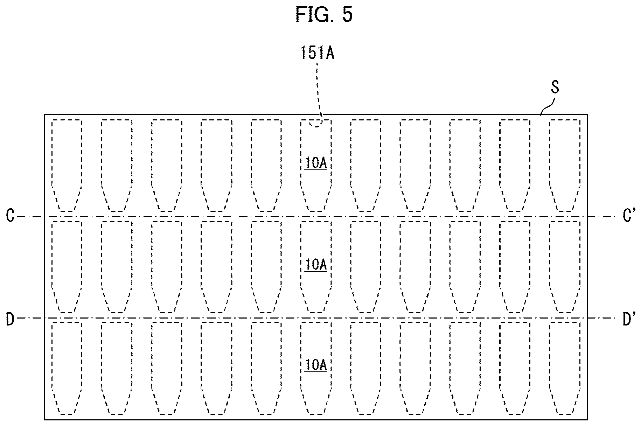

Fig. 5 is a plan view illustrating a plurality of chips that have been manufactured by the manufacturing method illustrated in Fig. 4.
(a) to (c) of Fig. 6 are cross-sectional views illustrating a method for manufacturing a second specific example of the chip illustrated in Fig. 2.
(a) of Fig. 7 is a plan view of a chip manufactured by using the manufacturing method illustrated in Fig. 6 when the chip is seen from a current injection stripe side. (b) of Fig. 7 is a plan view of a variation of the chip illustrated in (a) of Fig. 7 when seen from the current injection stripe side.

### Description of Embodiments

### [Configuration of chip-on-submount structure]

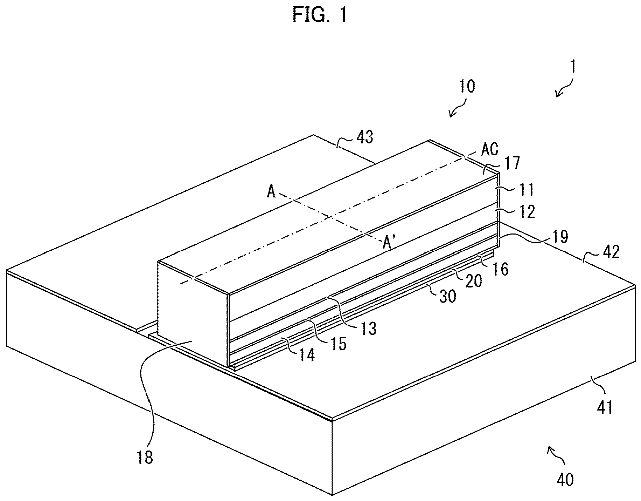

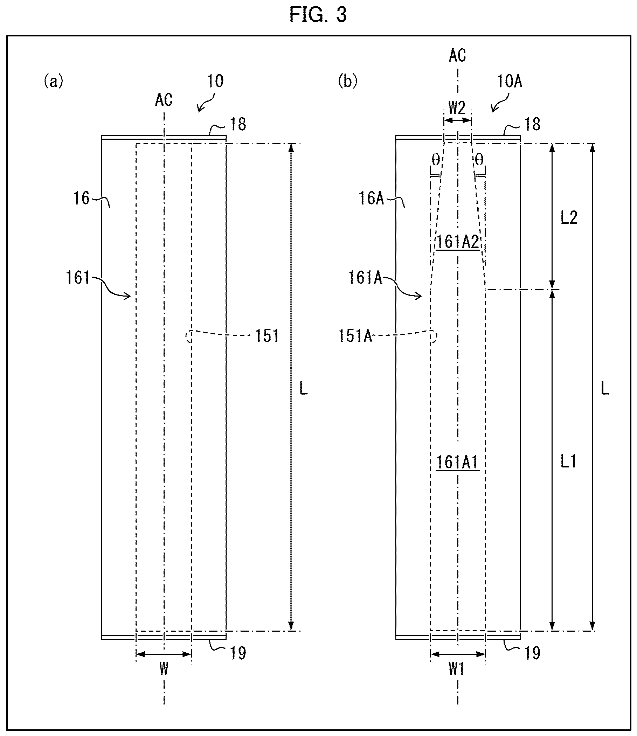

A chip-on-submount structure 1 in accordance with an embodiment of the present invention will be described with reference to Figs. 1 to 3. Fig. 1 is a perspective view of the chip-on-submount structure 1. Fig. 2 is a cross-sectional view of the chip-on-submount structure 1. The cross-sectional view in Fig. 2 is a cross-sectional view in a section A-A' that passes through a line A-A' illustrated in Fig. 1 and that is orthogonal to a main surface of a substrate 11. (a) of Fig. 3 is a plan view of a chip 10 provided in the chip-on-submount structure 1 when the chip 10 is seen in a plan view from a current injection stripe 161 side. (b) of Fig. 3 is a plan view of a chip 10A, which is a variation of the chip 10, when the chip 10A is seen in a plan view from a current injection stripe 161A side. Note that the chip 10 and the chip 10A are each an example of a semiconductor laser chip.

Note that the chip-on-submount structure 1 in accordance with an embodiment of the present invention will be described with use of the chip 10 having a simplified structure in the chip-on-submount structure 1 illustrated in Figs. 1 to 3. A more specific structure of the chip will be described later with reference to Figs. 4 and 6.

As illustrated in Figs. 1 and 2, the chip-on-submount structure 1 includes a chip 10, a distortion suppression layer 20, a solder layer 30, and a submount 40.

### <Submount>

The submount 40 is a base material for mounting the chip 10 on one main surface thereof. As illustrated in Figs. 1 and 2, the submount 40 includes a substrate 41 and electrode patterns 42 and 43. The electrode pattern 42 is an example of an electrode layer of the submount 40.

The substrate 41 is a plate-like member having a pair of flat main surfaces. The substrate 41 is composed of a high thermal conductivity material. In the present embodiment, ceramic having low electrical conductivity (preferably an insulator) and a high thermal conductivity is employed as the high thermal conductivity material of which the substrate 41 is composed. However, the high thermal conductivity material of which the substrate 41 is composed is not limited to a material having high electrical conductivity, and can be selected as appropriate in accordance with, for example, the configuration of the chip 10 and a preferable thermal conductivity of the substrate 41. In a case where the substrate 41 is composed of a conductor, a configuration can be employed in which the electrode pattern 42 described later and the electrode pattern 43 described later are insulated. In order to insulate the electrode pattern 42 and the electrode pattern 43, a configuration may be used in which an insulating layer is provided between the substrate 41 and the electrode pattern 42, and another insulating layer is provided between the substrate 41 and the electrode pattern 43, or an alternative configuration may be used in which a current is flowed in a direction perpendicular to the substrate.

The electrode pattern 42 and the electrode pattern 43 are formed on one main surface of the substrate 41. The electrode patterns 42 and 43 are each constituted by a thin film that is made of a material having electrical conductivity. In the present embodiment, gold, which is one kind of metal, is employed as a material of which each of the electrode patterns 42 and 43 is composed. However, the material of which each of the electrode patterns 42 and 43 is composed can be selected, as appropriate, from among materials having electrical conductivity. The material of which each of the electrode patterns 42 and 43 is composed preferably has good electrical conductivity. Examples of the materials having good electrical conductivity include gold, copper, silver, and aluminum. Further, each of the electrode patterns 42 and 43 may be a monolayer film that is made of any of these materials or may be a multilayer film in which each layer is made of any of these materials. The electrode patterns 42 and 43 are provided so as to be spaced apart from each other and are thus insulated from each other.

### <Chip>

The chip 10, which is an example of a semiconductor laser chip, employs 4 mm as a length L (see (a) of Fig. 3) that is a total length of the current injection stripe 161 which will be described later. That is, a resonator length in the chip 10 is 4 mm. In addition, the chip 10 is a broad area type chip in which the current injection stripe 161 has a width W (see (a) of Fig. 3) of not less than 75 µm throughout all of sections thereof. The broad area type chip 10 having the length L of 4 mm can emit laser light having an output power of not less than 10 W. Note that a minimum value of the width of the current injection stripe 161 is not limited to 75 µm, and, similarly, the output power of the chip 10 is not limited to 10 W. In addition, when mentioned in the present embodiment, the output power of the laser light in the chip 10 means a maximum output power of the chip 10. In the present embodiment, 4 mm and 220 µm are employed as the length L and the width W, respectively, and, in such a case, the output power exceeds 20 W. In the chip-on-submount structure 1, sufficiently dissipating heat generated in the chip 10 during driving enables stable emission of laser light of 13 W with respect to the width W of 100 µm. That is, in a case where 220 µm is employed as the width W, selecting the length L within the range of approximately not less than 4 mm and not more than 6 mm enables stable emission of laser light having an output power of approximately not less than 25 W and not more than 28 W.

As illustrated in Figs. 1 and 2, the chip 10 includes the substrate 11, an n-type layer 12, an active layer 13, a p-type layer 14, a block layer 15, an electrode layer 16, and an electrode layer 17.

### (Substrate)

The substrate 11 is a plate-like member that is made of a semiconductor and that has a pair of flat main surfaces 111, 112. In the present embodiment, the substrate 11 is made of GaAs. However, the material of which the substrate 11 is composed can be selected as appropriate.

The main surface 111, which is one main surface of the substrate 11 and is located on the upper side in Fig. 2, has the electrode layer 17 formed thereon. The electrode layer 17 is a metal thin film that is formed so as to cover the main surface 111. In the present embodiment, a three-layer film using Ni, Ge, and Au is employed as the electrode layer 17. However, the electrode layer 17 is not limited to this.

The main surface 112, which is another main surface of the substrate 11 and is located on the lower side in Fig. 2, has the n-type layer 12, the active layer 13, the p-type layer 14, and the electrode layer 16 stacked thereon in this order. The block layer 15 is embedded in an inner layer of the p-type layer 14.

### (n-type layer)

The n-type layer 12 is composed of an n-type semiconductor. Examples of the n-type semiconductor of which the n-type layer 12 is composed include a GaAs-based semiconductor (e.g., AlGaAs). The n-type layer 12 may have a multilayer structure in which individual layers are composed of different types of n-type semiconductors. In this case, the layers of the n-type layer 12 may be configured so as to be layers having different functions, such as a layer that functions as a buffer layer, a layer that functions as a cladding layer, and a layer that functions as a guide layer.

### (Active layer)

Examples of the semiconductor of which the active layer 13 is composed include GaAs-based semiconductors (e.g., InGaAs). However, a material can be selected as appropriate in accordance with a desired oscillation wavelength.

### (p-type layer)

The p-type layer 14 is composed of a p-type semiconductor. Examples of the p-type semiconductor of which the p-type layer 14 is composed include a GaAs-based semiconductor (e.g., AlGaAs). The p-type layer 14 may have a multilayer structure in which individual layers are composed of different types of p-type semiconductors. In this case, the layers of the active layer 13 may be configured so as to be layers having different functions, such as a layer that functions as a guide layer, a layer that functions as a cladding layer, and a layer that functions as a contact layer.

Among a pair of main surfaces of the p-type layer 14, a main surface which is on the opposite side from the active layer 13 (a main surface located on the lower side in Fig. 2) has the electrode layer 16 formed thereon. The electrode layer 16 is a metal thin film that is formed so as to cover, among the pair of main surfaces of the p-type layer 14, the main surface which is on the opposite side from the active layer 13. In the present embodiment, a two-layer film made of Ti and Au is employed as the electrode layer 16. However, the electrode layer 16 is not limited to this.

### (Electrode layer)

The electrode layer 16 and the electrode layer 17 function as a pair of electrodes that pass a current through the active layer 13. Hereinafter, when the main surface of the electrode layer 16 is seen in a plan view, a region via which a current is injected into the active layer 13 is referred to as a current injection stripe 161.

### (Block layer)

As illustrated in Fig. 2, the block layer 15 is provided to limit a region via which a current can be injected into the active layer 13 from the electrode layer 16. The block layer 15 is embedded in the inner layer of the p-type layer 14 so as to separate the electrode layer 16 and the active layer 13 from each other. The block layer 15 is composed of an n-type semiconductor that has electrical conductivity lower than that of the p-type semiconductor of which the p-type layer 14 is composed. Examples of a material of which the block layer 15 is composed include n-type GaAs. The block layer 15 has an opening 151 that is formed therein to limit a region via which a current injected from the electrode layer 16 is passed (see Fig. 2). In the present embodiment, when the main surface of the block layer 15 is seen in a plan view, the shape of the opening 151 is a rectangular shape (see (a) of Fig. 3). However, the shape of the opening 151 is not limited to a rectangular shape and may be, for example, a shape like an opening 151A illustrated in (b) of Fig. 3. The opening 151A will be described later. Note that, when the main surface of the electrode layer 16 is seen in a plan view, a region of the electrode layer 16 which overlaps the opening 151 and via which a current is injected into the active layer 13 is the current injection stripe 161. That is, the current injection stripe 161 also includes a region of the p-type layer 14 which is interposed between the electrode layer 16 and the active layer 13 and which overlaps the opening 151.

As described above, in the chip 10, the block layer 15 has an opening 151 formed therein. Therefore, among a pair of main surfaces of the block layer 15, in a main surface which is on the opposite side from the active layer 13 (a main surface located on the lower side in Fig. 2), a region corresponding to the opening 151 is recessed as compared with the region where the opening is not formed in the block layer 15 (see Fig. 2). Therefore, a surface of the current injection stripe 161 which is a region overlapping the opening 151 in a plan view is recessed as compared with a surface of a region that does not overlap the opening 151 in the electrode layer 16 in a plan view (see Fig. 2). The surface of the region that does not overlap the opening 151 in the electrode layer 16 in a plan view is the outermost surface of the chip 10 and is the outermost surface on the side where the distortion suppression layer 20 is provided.

### (Reflection film)

In the chip 10, each of a pair of end surfaces constituting a resonator has a corresponding one of a pair of reflection films formed thereon. In the chip 10, among the pair of end surfaces constituting the resonator illustrated in Fig. 1, one end surface (an end surface located on the left side in Fig. 1) has a low-reflection film 18 formed thereon, and another end surface (an end surface located on the right side in Fig. 1) has a high-reflection film 19 formed thereon. That is, spacing between the low-reflection film 18 and the high-reflection film 19 is equal to the resonator length of the chip 10. Further, the reflectivity of the low-reflection film 18 with respect to light of the oscillation wavelength is lower than the reflectivity of the high-reflection film with respect to the light.

The reflectivities of the high-reflection film and the low-reflection film can be each set as appropriate in accordance with the design of the chip 10. The configurations of the high-reflection film and the low-reflection film can be each selected as appropriate from among existing configurations. For example, as a low light reflection film having a relatively low reflectivity, a monolayer film made of a material such as Al₂O₃, AlN, Si, SiO₂, or TiO₂ or a multilayer film made of these materials can be used. In addition, as a high light reflection film having a relatively high reflectivity, a multilayer film obtained by repeatedly laminating a two-layer film made of these materials can be used.

### <Distortion suppression layer and solder layer>

As illustrated in Fig. 2, the distortion suppression layer 20 is a metal film that is formed on, among the pair of main surfaces of the electrode layer 16, a main surface which is on the opposite side from the active layer 13 (a main surface located on the lower side in Fig. 2). The distortion suppression layer 20 covers, in the electrode layer 16, the current injection stripe 161 and a region surrounding the current injection stripe 161.

In addition, the solder layer 30 is a metal layer that is interposed between the distortion suppression layer 20 and the electrode pattern 42.

In the present embodiment, gold is employed as a material of which the distortion suppression layer 20 is composed. However, the material of which the distortion suppression layer 20 is composed can be selected as appropriate from among metals that have good electrical conductivity and that are relatively soft. Examples of the metals that have good electrical conductivity and that are relatively soft include gold, copper, silver, and aluminum. Alternatively, the material of which the distortion suppression layer 20 is composed may be an alloy that contains, as a main component, any material selected from the group consisting of gold, copper, silver, and aluminum. Note that, in the present embodiment, the main component refers to a component having the highest composition ratio in the alloy of which the distortion suppression layer 20 is composed.

In addition, in the present embodiment, a plating method is used to form the distortion suppression layer 20. However, the method for forming the distortion suppression layer 20 is not limited to the plating method. The method for forming the distortion suppression layer 20 can be selected as appropriate from among methods that are capable of forming a film of a desired thickness (e.g., 2 µm or 3 µm). Another method for forming the distortion suppression layer 20 includes, for example, a sputtering method.

A material of which solder is composed before the solder layer 30 is formed is not particularly limited. The material of which the solder is composed can be selected as appropriate in accordance with a desired property.

The chip 10 is joined to the submount 40 by joining the distortion suppression layer 20 and the electrode pattern 42 via the solder layer 30.

In a step of joining the chip 10 to the submount 40 with use of this solder, the distortion suppression layer 20 and the electrode pattern 42 are joined by forming the solder layer 30 in such a manner that solder has been melted and then solidified again. While this solder is changing into the solder layer 30, the component of the solder layer 30 is diffused into the distortion suppression layer 20. Thus, an alloy of the material (gold in the present embodiment) of which the distortion suppression layer 20 is composed and the component of the solder layer 30 is formed in the vicinity of an interface between the distortion suppression layer 20 and the solder layer 30.

Hereinafter, in the strain suppression layer 20, a layer in which the component of the solder layer 30 is diffused is referred to as a reaction layer 202, and a layer in which the component of the solder layer 30 is not diffused is referred to as an unreacted layer 201. The thicknesses of the unreacted layer 201 and the reaction layer 202 in the region overlapping the current injection stripe 161 when seen in a plan view are referred to as a thickness t1 and a thickness t2. In the chip 10, the thickness of the distortion suppression layer 20 (a sum of the thickness t1 and the thickness t2) is determined such that the thickness t1 is not less than 1.4 µm in a state in which the distortion suppression layer 20 and the electrode pattern 42 are joined via the solder layer 30. In addition, the thickness t1 is preferably not less than 2.0 µm.

The material(s) of which the distortion suppression layer 20 is composed, such as gold, copper, silver, and aluminum, are known as relatively soft materials among metals. Since the distortion suppression layer 20, which is composed of a soft material(s), enables reduction of a distortion that can occur when the chip 10 is joined to the submount 40 with use of the solder layer 30. As a result, it is possible to make the chip 10 less likely to be affected by the distortion caused by the joining. Note that the materials such as gold, copper, silver, and aluminum may harden by reacting with solder. In such a case, in order to suppress a distortion, it is important that the unreacted layer 201, which does not react with the solder, in a state of having a sufficient thickness is interposed between the electrode layer 16 and the reaction layer 202. The inventors of the present invention conducted a study on the thickness of the unreacted layer 201 in the chip 10 which was extracted from a group of chips 10 that were statistically considered not to have any failure resulting from the distortion that occurred during the joining. As a result, the thickness of the unreacted layer 201 in the chip 10 that was considered not to have any failure resulting from the distortion was 2030 nm on average, and a standard deviation σ was 207 nm. Considering various process variations, it is presumed that, in this group, there was an unreacted layer 201 probabilistically having a thickness greater than 3 σ, that is, there was an unreacted layer 201 having a thickness of not less than 1.4 µm. Therefore, the presence of an unreacted layer 201 having a thickness of at least not less than 1.4 µm enables the distortion suppression layer 20 to eliminate stress generated by a reaction between plating and solder.

### <Symmetry of current injection stripe>

As illustrated in Fig. 1, the chip-on-submount structure 1 is such that the chip 10 having a columnar shape and the submount 40 are joined to each other via the distortion suppression layer 20 and the solder layer 30. The low-reflection film 18 and the high-reflection film 19 are formed on corresponding ones of the pair of end surfaces of the columnar chip 10. Further, the electrode layer 16 and the electrode layer 17 are formed on corresponding ones of the pair of side surfaces of the columnar chip 10 (see Fig. 2). The electrode layer 16 is connected to the electrode pattern 42 via the distortion suppression layer 20 and the solder layer 30.

When the chip-on-submount structure 1 having such a configuration is seen in a plan view from the direction normal to the main surface of the active layer 13 (in Fig. 1, the same direction as the direction normal to the main surface of the electrode layer 17), the chip 10 has a strip shape (see (a) of Fig. 3). In the present embodiment, an axis that is parallel to the longitudinal direction of the chip 10 and that bisects the active layer 13 in the plan view is referred to as a central axis AC of the chip 10 (see Fig. 2 and (a) of Fig. 3). In the chip 10, in the plan view, the current injection stripe 161 is provided so as to overlap the central axis AC.

Further, in the section A-A' illustrated in Fig. 2, the current injection stripe 161 has line symmetry with respect to a symmetrical axis that is an axis (line B-B') which passes through the central axis AC and which is orthogonal to the main surface of the active layer 13. Thus, in an aspect of the present invention, it is preferable that the chip 10 including the current injection stripe 161 have line symmetry with respect to the symmetrical axis. Further, similarly, it is preferable that the distortion suppression layer 20 and the solder layer 30 also have line symmetry with respect to the symmetrical axis. However, the submount 40 does not necessarily need to have line symmetry with respect to the symmetrical axis.

### <Variation of chip>

The chip 10A, which is a variation of the chip 10, will be described with reference to (b) of Fig. 3. The chip 10A is obtained by changing the shape of the opening 151 (see (a) of Fig. 3), which is provided in the block layer 15 of the chip 10, such that the opening 151 is shaped like an opening 151A (see (b) of Fig. 3). In the features other than the shape of the opening 151A, the chip 10A is the same as the chip 10. Note that, in the present variation, the electrode layer 16 and the current injection stripe 161 in the chip 10 are read as an electrode layer 16A and a current injection stripe 161A, respectively. That is, when the main surface of the electrode layer 16A is seen in a plan view, the current injection stripe 161A is a region which overlaps the opening 151A and via which a current is injected into the active layer 13. The current injection stripe 161A also includes a region of the p-type layer 14 which is interposed between the electrode layer 16A and the active layer 13 and which overlaps the opening 151A.

Note that, for convenience of description, a member having a function identical to that of a member described with respect to the chip 10 is given an identical reference sign, and a description thereof is omitted.

As in the case of the chip 10, the low-reflection film 18 and the high-reflection film 19 are formed on corresponding ones of the pair of end surfaces of the chip 10A. The low-reflection film 18 and the high-reflection film 19 constitute a resonator.

In the chip 10A, the current injection stripe 161A is constituted by a first section 161A1 and a second section 161A2. Note that, hereinafter, the width of the first section 161A1 and the width of the second section 161A2 are denoted as a width W1 and a width W2, respectively. The first section 161A1 is a section that has the width W1 which is constant and that is located on a high-reflection film 19 side. The second section 161A2 is a section that has the width W2 which decreases in a tapered shape with distance from the first section 161A1 and that is located on a low-reflection film 18 side. As can be seen from (b) of Fig. 3, the width W2 becomes maximum and becomes equal to the width W1 at the boundary between the first section 161A1 and the second section 161A2. In the present variation, 220 µm is employed as the width W1, 220 µm is employed as a maximum value of the width W2, and 180 µm is employed as a minimum value of the width W2. Further, other examples of the minimum value of the width W2 include 150 µm. In the present variation, as illustrated in (b) of Fig. 3, a trapezoidal shape (more specifically, isosceles trapezoidal shape) is employed as the shape of the second section 161A2.

Hereinafter, the total length of the current injection stripe 161A is referred to as a length L, the length of the first section 161A1 is referred to as a length L1, and the length of the second section 161A2 is referred to as a length L2. In the chip 10A, the length L is substantially equal to the length of the resonator.

In the chip 10A, the length L is 4 mm, the length L1 is 3200 µm, and the length L2 is 800 µm. In the present variation, in the second section 161A2 in which the length L2 is 800 µm, the width W2 decreases by 40 µm from 220 µm to 180 µm. Thus, a ratio of an area of the second section 161A2 with respect to an area of the current injection stripe 161A is 18.5%, and a taper angle θ of the second section 161A2 when the current injection stripe 161 is seen in a plan view is 1.43°. Further, another parameter related to the shape of the second section 161A2 can also be expressed as a ratio of the area of the second section 161A2 with respect to the area of the current injection stripe 161 in the chip 10 (see (a) of Fig. 3) in which the second section 161A2 is not provided. In the chip 10A described above, this ratio is 18.2%. Further, as further another parameter related to the shape of the second section 161A2, a ratio of a difference calculated between the area of the current injection stripe 161 in the chip 10 and the area of the current injection stripe 161A with respect to the area of the current injection stripe 161 can also be used. In a case where the current injection stripe 161 is assumed to be changed in shape to the current injection stripe 161A, the difference corresponds to an area of a tapered portion which is tapered in a tapered shape such that the width W2 of the second section 161A2 decreases with distance from the first section 161A1. In the chip 10A, the ratio of the difference in the area of the current injection stripe 161 is 1.82%. Note that, hereinafter, numerical values of the ratio and the taper angle θ are each indicated by three significant figures. Here, the taper angle θ is an angle formed by the central axis AC and each leg of the second section 161A2, which is trapezoidal (isosceles trapezoidal in the present embodiment). Note that the length L, the length L1, the length L2, the width W1, the minimum value of the width W2, and the taper angle θ are not each limited to this.

Note that, in a case where 800 µm is employed as the length L2, and 150 µm is employed as the minimum value of the width W2, the ratio of the area of the second section 161A2 with respect to the area of the current injection stripe 161A is 17.4%, the taper angle θ of the second section 161A2 when the current injection stripe 161 is seen in a plan view is 2.51 °, the ratio of the area of the second section 161A2 with respect to the area of the current injection stripe 161 in the chip 10 (see (a) of Fig. 3) in which the second section 161A2 is not provided is 16.8%. Further, the ratio of the difference between the area of the current injection stripe 161 in the chip 10 and the area of the current injection stripe 161A with respect to the area of the current injection stripe 161 is 3.18%.

Note that the inventors of the present invention simulated the length L, the length L1, the length L2, the width W1, the minimum value of the width W2, and the taper angle θ, and, as a result of the simulations, the following was found.

First, increasing the taper angle θ makes it possible to enhance coupling efficiency in optically coupling laser light emitted by the chip-on-submount structure 1 and the core of an optical fiber, in other words, laser light extraction efficiency. However, it was found that excessively increasing the taper angle θ causes the radial shape of laser light to become deformed. The inventors found that deformation which can be caused in the radial shape of laser light when the taper angle θ is less than 2.51° can be tolerated. Thus, the taper angle θ is preferably less than 2.51° (first condition).

Further, in a case where the taper angle θ is constant, the larger the length L2, the smaller a minimum value of the width W2. That is, it is possible to enhance the above-mentioned coupling efficiency. However, as the length L2 is increased, the area of the current injection stripe 161 is reduced. This increases an operating voltage during driving of the chip 10 and, in turn, increases power consumption of the chip 10. The inventors found that, in order to achieve both high coupling efficiency and low power consumption, the width W2 is preferably not less than 150 µm in a case where 220 µm is employed as the width W1. In other words, the inventors found that the minimum value of the width W2 is preferably not less than 68.2% of a maximum value of the width W2 (second condition). In addition, the inventors found that, if the ratio of the area of the second section 161A2 with respect to the area of the current injection stripe 161A is not less than 17.4%, an increase in the operating voltage during the driving can be tolerated. In other words, the inventors found that, if the ratio of the area of the second section 161A2 with respect to the area of the current injection stripe 161 in the chip 10 in which the second section 161A2 is not provided is not less than 16.8%, an increase in the operating voltage during the driving can be tolerated. In further other words, the inventors found that, if the ratio of the difference between the area of the current injection stripe 161 in the chip 10 and the area of the current injection stripe 161A with respect to the area of the current injection stripe 161 is not more than 3.18%, an increase in the operating voltage during the driving can be tolerated. Thus, when the current injection stripe 161A is seen in a plan view, it is preferable that at least one of the following: (1) the ratio of the area of the second section 161A2 with respect to the area of the current injection stripe 161A is not less than 17.4%, (2) the ratio of the area of the second section 161A2 with respect to the area of the current injection stripe 161 in the chip 10 in which the second section 161A2 is not provided is not less than 16.8%, and (3) the ratio of the difference between the area of the current injection stripe 161 in the chip 10 and the area of the current injection stripe 161A with respect to the area of the current injection stripe 161 is not more than 3.18% be satisfied (third condition).

In an aspect of the present invention, satisfying the above-described three conditions (first condition to third condition) makes it possible to suppress a loss of electric power while increasing the beam quality of laser light.

Further, as illustrated in (f) of Fig. 4, one variation of the chip 10 may further include a reaction control layer 21 that covers, among a pair of main surfaces of the distortion suppression layer 20, a main surface which is on the opposite side from the active layer 13. The reaction control layer 21 is an element for suppressing diffusion of the component of the solder layer 30 into the distortion suppression layer 20 when the chip 10 is joined to the submount 40 with use of the solder layer 30. Examples of the reaction control layer 21 include a two-layer film, such as a two-layer film made of Pt and Au and a two-layer film made of Ti and Au, and a three-layer film made of Ti, Pt, and Au.

In a case where the formation of the distortion suppression layer 20 by a plating method is followed by formation of the reaction control layer 21 also by a plating method, a material of the reaction control layer 21 can be selected from among, for example, platinum, palladium, copper, nickel, and a two-layer film made of Pt and Au. Note, however, that a method for forming the reaction control layer 21 and elements of the reaction control layer 21 can be selected as appropriate without being limited.

Note that the chip 10A (see (b) of Fig. 3) including the second section 161A2, which has the width W2 that gradually decreases toward the tip of the current injection stripe 161, is likely to undergo distortion when the chip 10A is joined to the submount 40, as compared with the chip 10 illustrated in (a) of Fig. 3. Therefore, the effect brought about by providing the distortion suppression layer 20 is greater in the case of the chip 10A than in the case of the chip 10.

### [Method for manufacturing chip]

A method for manufacturing the chip 10A will be described with reference to Figs. 4 and 5. In the description of the present manufacturing method, a first specific example of the chip 10 illustrated in Figs. 1 to 3 is used. (a) to (f) of Fig. 4 are cross-sectional views illustrating a method for manufacturing the first specific example of the chip 10 illustrated in Fig. 2. The present manufacturing method includes a lamination step, an opening formation step, a contact layer lamination step, a first electrode layer lamination step, a mask formation step, a distortion suppression layer lamination step, a window formation step, a second electrode layer lamination step, and a cleavage step. Fig. 5 is a plan view illustrating a plurality of chips 10 that have been manufactured by the present manufacturing method.

(a) of Fig. 4 illustrates a state of the substrate 11 after the lamination step has been carried out. The lamination step is a step of laminating, on the main surface 112 of the substrate 11, a buffer layer 121, an n-type cladding layer 122, an n-type guide layer 123, an active layer 13, a p-type guide layer 141, a p-type cladding layer 142, and a block layer 150. In the present manufacturing method, an MOCVD method is used to laminate these layers.

The buffer layer 121, the n-type cladding layer 122, and the n-type guide layer 123 correspond to the n-type layer 12 illustrated in Figs. 1 and 2. Further, the p-type guide layer 141 and the p-type cladding layer 142, together with a p-type contact layer 143 described later, correspond to the p-type layer 14 illustrated in Figs. 1 and 2.

In the present manufacturing method, a GaAs wafer is used as the substrate 11. Further, GaAs is used as a material of which the buffer layer 121 is composed, Alₓ₁Ga_{1-xA}S is used as a material of which the n-type cladding layer 122 is composed, Alₓ₂Ga₁₋ₓ₂As is used as a material of which the n-type guide layer 123 is composed, undoped InGaAs is used as a material of which the active layer 13 is composed, Alₓ₃Ga₁₋ₓ₃As is used as a material of which the p-type guide layer 141 is composed, Alₓ₄Ga₁₋ₓ₄As is used as a material of which the p-type cladding layer 142 is composed, and n-type GaAs is used as a material of which the block layer 150 is composed. Here, x1>x2, and x4>x3. Note that the block layer 150 is a solid film having no opening and is thus given 150 as a reference sign to be distinguished from a block layer 15 described later. For the active layer 13, the composition and film thickness can be adjusted as appropriate so that a desired oscillation wavelength is obtained.

(b) of Fig. 4 illustrates a state of the substrate 11 after the opening formation step has been carried out. The opening formation step is a step of forming an opening 151 in the block layer 150 which is a solid film. In the present manufacturing method, photolithography and etching are used to form the opening 151. Note that, if a surface treatment is required in the opening formation step, shallow etching by HF or an inorganic acid may be carried out.

(c) of Fig. 4 illustrates a state of the substrate 11 after the contact layer lamination step has been carried out. The contact layer lamination step is a step of laminating the p-type contact layer 143 on the p-type cladding layer 142 and the block layer 15. In the present manufacturing method, p-type GaAs is used as a material of which the p-type contact layer 143 is composed. By carrying out the above steps, a chip of self-aligned structure (SAS) is obtained.

Note that, with regard to variations of compositions of the above-described layers, layer thickness, doping, and the like, combinations thereof suitable for laser oscillation are myriad. Thus, a combination by which a desired laser oscillation property is obtained can be selected. For layers having the same function among the above-described layers, a configuration which realizes the same function can be selected as appropriate. The above-described layers may be each a monolayer film or a multilayer film.

In addition, in the present manufacturing method, a GaAs-based material is used as a material of which the n-type layer 12, the active layer 13, and the p-type layer 14 are composed. Note, however, that an AlInGaP-based material lattice-matched with the GaAs substrate 11 can be used as the material of which the n-type layer 12, the active layer 13, and the p-type layer 14 are composed.

(d) of Fig. 4 illustrates a state of the substrate 11 after the first electrode layer lamination step has been carried out. The first electrode layer lamination step is a step of laminating the electrode layer 16 on the p-type contact layer 143. In the present manufacturing method, a two-layer film made of Ti and Au is used as the electrode layer 16. Note that a region of the electrode layer 16 which overlaps the opening 151 functions as a current injection stripe 161. By carrying out the above-described steps, the chip 10 is obtained.

(e) of Fig. 4 illustrates a state of the substrate 11 after the mask formation step has been carried out. The mask formation step is a step of forming a photomask M on the electrode layer 16. The photomask M has formed therein an opening corresponding to a region where the distortion suppression layer 20 is formed.

(f) of Fig. 4 illustrates a state of the substrate 11 after the distortion suppression layer lamination step has been carried out. The distortion suppression layer lamination step is a step of laminating the distortion suppression layer 20 and the reaction control layer 21 on the electrode layer 16 and the photomask M. In the present manufacturing method, a plating method is used to laminate the distortion suppression layer 20 and the reaction control layer 21. In the present manufacturing method, Au is used as a material of which the distortion suppression layer 20 is composed, and a two-layer film made of Pt and Au is used as the reaction control layer 21. Then, the photomask M is lifted off. In this way, the chip 10 including the distortion suppression layer 20 and the reaction control layer 21 is obtained.

A method for growing the above-described layers is not limited to the MOCVD method. Alternatively, a liquid phase epitaxy method, a molecular beam epitaxy method, or the like may be used.

Fig. 5 illustrates a plurality of chips 10A that have been manufactured on a main surface of one substrate S made of GaAs. In Fig. 5, three laser bars are provided. Note that, in Fig. 5, for explanation, a portion of the substrate S (a region including the three laser bars) is illustrated in an enlarged view. More laser bars are provided on the main surface of the substrate S. Each of the laser bars is constituted by a plurality of chips 10A. Note that, for the manufacture of the chip 10A, which differs from the chip 10 only in that the shape of the opening 151A differs from the shape of the opening 151 of the chip 10, the above-described manufacturing method can be used.

The second electrode layer lamination step is a step of laminating the electrode layer 17 on the main surface 111 of the substrate 11. In the second electrode layer lamination step, the thickness of the substrate 11 is adjusted by grinding and polishing the main surface 111, and then the electrode layer 17 made of Ni, Ge, and Au is laminated. Examples of a method for laminating the electrode layer 17 include, but not limited to, an electron beam vapor deposition method and a sputtering method.

Further, in the second electrode layer lamination step, a heat treatment may be carried out after the electrode layer 17 has been laminated. The temperature of the heat treatment can be determined, as appropriate, and is, for example, 400°C.

In addition, on the electrode layer 17, a metallized layer (for example, Ti, Pt, and Au) in which a surface thereof is made of Au may be provided. In this way, it is possible to enhance wire bondability with the electrode pattern 43 of the submount 40 or with an external electrode.

The cleavage step is a step of cleaving the substrate S illustrated in Fig. 5, for example, at the position of a line C-C' and at the position of a line D-D' to obtain individual laser bars. Further, in a case where individual chips 10A are to be obtained from one laser bar, adjacent chips 10A can be separated from each other. This separation may be carried out by cleavage of the substrate S that constitutes the laser bars or may be carried out by dicing.

### [Second specific example of chip]

A second specific example of the chip 10 will be described with reference to Figs. 6 and 7. (a) to (c) of Fig. 6 are cross-sectional views illustrating a method for manufacturing a second specific example of the chip 10. The method for manufacturing the second specific example differs in the lamination step from the manufacturing method illustrated in Fig. 4. In addition, a method for forming the block layer 15 following the lamination step also differs. (a) of Fig. 7 is a plan view of the second specific example of the chip 10 when seen from a current injection stripe 161B side. (b) of Fig. 7 is a plan view of a variation of the second specific example illustrated in (a) of Fig. 7 when seen from a current injection stripe 161C side.

Note that, for convenience of description, a member having a function identical to that of a member described with respect to the chip 10 is given an identical reference sign, and a description thereof is omitted.

(a) of Fig. 6 illustrates a state of the substrate 11 after the lamination step and the mask formation step have been carried out. The lamination step is a step of laminating, on the main surface 112 of the substrate 11, a buffer layer 121, an n-type cladding layer 122, an n-type guide layer 123, an active layer 13, a p-type guide layer 141, a p-type cladding layer 142, an etching stop layer 14s, and a p-type contact layer 143. The mask formation step is a step of forming a photomask M on the p-type contact layer 143. The etching stop layer 14s is composed of a material having an etching rate lower than that of the p-type contact layer 143. Suitable combinations of the material of which the etching stop layer 14s is composed and a method used for etching of the p-type contact layer 143 are myriad. Thus, a suitable combination of the material of which the etching stop layer 14s is composed and the method used for etching of the p-type contact layer 143 can be selected as appropriate from among existing suitable combinations. For example, AlGaAs is used as the material of which the etching stop layer 14s is composed, and a citric acid-based etching solution can be used as the method used for etching of the p-type contact layer 143.

(b) of Fig. 6 illustrates a state of the substrate 11 after the etching step has been carried out. The etching step is a step of etching the p-type contact layer 143 to a depth reaching the etching stop layer 14s to form two grooves 14t. As a result, a region of the p-type contact layer 143 which is sandwiched between the two grooves 14t is patterned in the shape of a ridge. Note that (b) of Fig. 6 illustrates the substrate 11 in a state in which the photomask M is removed after the etching step has been carried out.

(c) of Fig. 6 illustrates a state of the substrate 11 after a dielectric layer formation step has been carried out. The dielectric layer formation step is a step of forming a dielectric layer 15A on the p-type contact layer 143 and the etching stop layer 14s. The dielectric layer 15A is composed of a dielectric having electrical conductivity lower than that of a p-type semiconductor of which the p-type contact layer 143 is composed.

Note that, although the description is omitted here, it is possible to obtain the second specific example of the chip 10 by, after a block layer formation step, carrying out, the first electrode layer lamination step, the mask formation step, the distortion suppression layer lamination step, the window formation step, the second electrode layer lamination step, and the cleavage step, which have been described above.

Hereinafter, the second specific example of the chip 10 is referred to as a chip 10B (see (a) of Fig. 7). Further, a variation of the chip 10B is referred to as a chip 10C (see (b) of Fig. 7). The chip provided in the chip-on-submount structure 1 may be a chip, like the chip 10 (see (a) of Fig. 3 and Fig. 4) and the chip 10A (see (b) of Fig. 3), in which two grooves are not formed in the p-type contact layer 143 or may be a chip, like the chip 10B and the chip 10C, in which two grooves 14t are formed to form the p-type contact layer 143 in the shape of a ridge. Further, in the chip provided in the chip-on-submount structure 1, the current injection stripe 161 having a constant width W as in the chip 10 may be employed in the chip that includes the ridge-shaped p-type contact layer 143.

Aspects of the present invention can also be expressed as follows:
In order to solve the above problem, a chip-on-submount structure in accordance with a first aspect of the present invention includes: a broad area type chip that includes an active layer and a current injection stripe which injects a current into the active layer; a distortion suppression layer that covers the current injection stripe and that is made of a metal; a submount that includes a substrate and an electrode layer which is provided on one main surface of the substrate; and a solder layer that is interposed between the distortion suppression layer and the electrode layer and that joins the chip and the submount. In the present chip-on-submount structure, a configuration is employed in which the distortion suppression layer consists of a reaction layer, in which a component of the solder layer is diffused, and an unreacted layer, in which the component of the solder layer is not diffused, and the unreacted layer has a thickness of not less than 1.4 µm.

The distortion suppression layer included in the chip-on-submount structure in accordance with the first aspect is configured such that the unreacted layer has a thickness of not less than 1.4 µm, and it is thus possible to suppress distortions that can occur in the step of joining the chip to the submount with use of solder. Thus, the present chip-on-submount structure can stabilize the radial shape of laser light.

Further, a chip-on-submount structure in accordance with a second aspect of the present invention employs, in addition to the above-described configuration of the chip-on-submount structure in accordance with the first aspect, a configuration in which the distortion suppression layer contains gold as a main component.

Gold is a relatively soft metal. According to the above configuration, a relatively soft metal is interposed between the chip and the submount. Thus, it is possible to reliably suppress the above-described distortions. In addition, gold has high electrical conductivity and high thermal conductivity. Thus, the present chip-on-submount structure can reduce a loss of electric power that can occur in a case where a drive current is supplied to the chip and can efficiently release heat that can generate in the chip to the submount.

Further, a chip-on-submount structure in accordance with a third aspect of the present invention employs, in addition to the above-described configuration of the chip-on-submount structure in accordance with the first aspect or the second aspect, a configuration in which, when a main surface of the active layer is seen in a plan view from a direction normal to the main surface of the active layer, the chip has a strip shape, and the current injection stripe is provided so as to overlap a central axis of the strip-shaped chip.

Heat generated during driving of a chip is likely to generate in the vicinity of the active layer overlapping the current injection stripe when seen in a plan view. According to the above configuration, it is possible to increase the symmetry of the current injection stripe inside the chip. Thus, the present chip-on-submount structure can suppress thermal distortions that can occur during driving of the chip.

Further, a chip-on-submount structure in accordance with a fourth aspect of the present invention employs, in addition to the above-described configuration of the chip-on-submount structure in accordance with the third aspect, a configuration in which, in a cross section of the chip that is parallel to each of a pair of end surfaces of the chip which constitute a resonator, the current injection stripe has line symmetry with respect to a symmetrical axis that is an axis which passes through the central axis and which is orthogonal to the main surface of the active layer.

According to the above configuration, it is possible to further increase the symmetry of the current injection stripe inside the chip. Thus, the present chip-on-submount structure can further suppress thermal distortions that can occur in the chip during driving of the chip.

Further, a chip-on-submount structure in accordance with a fifth aspect of the present invention employs, in addition to the above-described configuration of the chip-on-submount structure in accordance with the third aspect, a configuration in which, the current injection stripe is recessed more than an outermost surface of the chip that is on a side where the distortion suppression layer is provided.

According to the above configuration, it is possible to suppress distortion that may occur in the step of joining the chip to the submount using the solder, as compared with a case where the current injection stripe is raised more than the outermost surface of the chip that is on the side where the distortion suppression layer is provided. Thus, the present chip-on-submount structure can further stabilize the radial shape of laser light.

Further, a chip-on-submount structure in accordance with a sixth aspect of the present invention employs, in addition to the above-described configuration of the chip-on-submount structure in accordance with any one aspect of the first aspect to the third aspect, a configuration in which the chip further includes a high-reflection film and a low-reflection film that constitute a resonator of the chip, the low-reflection film having a reflectivity lower than that of the high-reflection film. In the present chip-on-submount structure, the current injection stripe is constituted by a first section and a second section, the first section having a constant width and being located on a side where the high-reflection film is provided, the second section having a width that decreases with distance from the first section and being located on a side where the low-reflection film is provided.

According to the above configuration, it is possible to improve the beam quality of laser light emitted by the chip. Thus, the present chip-on-submount structure can enhance coupling efficiency in optically coupling laser light and a core of an optical fiber, in other words, laser light extraction efficiency.

Further, a chip-on-submount structure in accordance with a seventh aspect of the present invention employs, in addition to the above-described configuration of the chip-on-submount structure in accordance with the sixth aspect, a configuration in which, when a main surface of the current injection stripe is seen in a plan view from a direction normal to the main surface of the current injection stripe, the chip has a strip shape, the second section is shaped in a trapezoid such that the width of the second section decreases with distance from the first section, in the second section, a ratio of a minimum value of the width with respect to a maximum value of the width is not less than 68.2%, a ratio of an area of the second section with respect to an area of the current injection stripe is not less than 17.4%, and a taper angle θ, which is an angle formed by a central axis of the strip-shaped chip and each of legs of the trapezoid that constitute the second section, is not less than 0° and less than 2.51°.

Satisfying the above-described two conditions makes it possible to suppress a loss of electric power that can occur during driving of the chip while increasing the beam quality of laser light.

Further, a chip-on-submount structure in accordance with an eighth aspect of the present invention employs, in addition to the above-described configuration of the chip-on-submount structure in accordance with any one aspect of the first aspect to the seventh aspect, a configuration in which the chip-on-submount structure further includes a reaction control layer that is provided between the distortion suppression layer and the solder layer and that is constituted by a multilayer film which is made of metals.

According to the above configuration, the reaction control layer is interposed between the distortion suppression layer and the solder layer, and it is thus possible to suppress diffusion of the component of the solder layer into the distortion suppression layer. Thus, the present chip-on-submount structure can easily secure the unreacted layer having a thickness of not less than 1.4 µm, as compared to a case where the distortion suppression layer and the solder layer are directly joined.

Further, a chip-on-submount structure in accordance with a ninth aspect of the present invention employs, in addition to the above-described configuration of the chip-on-submount structure in accordance with any one aspect of the first aspect to the eighth aspect, a configuration in which the current injection stripe has a width of not less than 75 µm throughout all of sections thereof.

The configuration in which the thickness of the unreacted layer in the distortion suppression layer is not less than 1.4 µm is suitable for a chip-on-submount structure that includes a broad area type chip in which the current injection stripe has a width of not less than 75 µm throughout all of sections thereof. Such a broad area type chip can emit laser light having output power of not less than 10 W.

### [Supplemental notes]

The present invention is not limited to the embodiments, but can be altered by a skilled person in the art within the scope of the claims. The present invention also encompasses, in its technical scope, any embodiment derived by combining technical means disclosed in differing embodiments.

### Reference Signs List

1: chip-on-submount structure
10, 10A: chip
11: substrate
12: n-type layer
121: buffer layer
122: n-type cladding layer
123: n-type guide layer
13: active layer
14: p-type layer
14t: groove
141: p-type guide layer
142: p-type cladding layer
143: p-type contact layer
15: block layer
15A: dielectric layer
16, 17: electrode layer
161: current injection stripe
18: low-reflection film
19: high-reflection film
20: distortion suppression layer
21: reaction control layer
30: solder layer
40: submount
41: substrate
42, 43: electrode pattern

## Claims

1. A chip-on-submount structure comprising:
a broad area type chip that includes an active layer and a current injection stripe which injects a current into the active layer;
a distortion suppression layer that covers the current injection stripe and that is made of a metal;
a submount that includes a substrate and an electrode layer which is provided on one main surface of the substrate; and
a solder layer that is interposed between the distortion suppression layer and the electrode layer and that joins the chip and the submount,
the distortion suppression layer consisting of a reaction layer, in which a component of the solder layer is diffused, and an unreacted layer, in which the component of the solder layer is not diffused,
the unreacted layer having a thickness of not less than 1.4 µm.

2. The chip-on-submount structure according to claim 1, wherein the distortion suppression layer contains gold as a main component.

3. The chip-on-submount structure according to claim 1 or 2, wherein
when a main surface of the active layer is seen in a plan view from a direction normal to the main surface of the active layer,
the chip has a strip shape, and
the current injection stripe is provided so as to overlap a central axis of the strip-shaped chip.

4. The chip-on-submount structure according to claim 3, wherein
in a cross section of the chip that is parallel to each of a pair of end surfaces of the chip which constitute a resonator,
the current injection stripe has line symmetry with respect to a symmetrical axis that is an axis which passes through the central axis and which is orthogonal to the main surface of the active layer.

5. The chip-on-submount structure according to claim 3, wherein
the current injection stripe is recessed more than an outermost surface of the chip that is on a side where the distortion suppression layer is provided.

6. The chip-on-submount structure according to any one of claims 1 to 3, wherein:
the chip further includes a high-reflection film and a low-reflection film that constitute a resonator of the chip, the low-reflection film having a reflectivity lower than that of the high-reflection film; and
the current injection stripe is constituted by a first section and a second section, the first section having a constant width and being located on a side where the high-reflection film is provided, the second section having a width that decreases with distance from the first section and being located on a side where the low-reflection film is provided.

7. The chip-on-submount structure according to claim 6, wherein
when a main surface of the current injection stripe is seen in a plan view from a direction normal to the main surface of the current injection stripe,
the chip has a strip shape,
the second section is shaped in a trapezoid such that the width of the second section decreases with distance from the first section,
in the second section, a ratio of a minimum value of the width with respect to a maximum value of the width is not less than 68.2%,
a ratio of an area of the second section with respect to an area of the current injection stripe is not less than 17.4%, and
a taper angle θ, which is an angle formed by a central axis of the strip-shaped chip and each of legs of the trapezoid that constitute the second section, is not less than 0° and less than 2.51°.

8. The chip-on-submount structure according to any one of claims 1 to 7, further comprising
a reaction control layer that is provided between the distortion suppression layer and the solder layer and that is constituted by a multilayer film which is made of metals.

9. The chip-on-submount structure according to any one of claims 1 to 8, wherein
the current injection stripe has a width of not less than 75 µm throughout all of sections thereof.
